# FASCICULE DE BREVET EUROPEEN

(11) **EP 3 788 645 B1**
(45) Date de publication et mention de la délivrance du brevet: **09.11.2022**
(21) Numéro de dépôt: 19722833.1
(22) Date de dépôt: 30.04.2019
(51) Int. Cl.: H01J 37/26, H01J 37/317, C30B 23/08, H01L 21/203

(54) **MICROSCOPE ELECTRONIQUE EN TRANSMISSION EQUIPÉ D'AU MOINS UNE SOURCE DE JET DE MATIÈRE BALISTIQUE**
TRANSMISSIONSELEKTRONENMIKROSKOP MIT MINDESTENS EINER BALLISTISCHEN MATERIALSTRAHLQUELLE
TRANSMISSION ELECTRON MICROSCOPE PROVIDED WITH AT LEAST ONE BALLISTIC MATERIAL JET SOURCE

(30) Priorité: 02.05.2018 FR 1853774
(43) Date de publication de la demande: 10.03.2021
(73) Titulaire: Centre national de la recherche scientifique, 75016 Paris (FR)
(72) Inventeur: HARMAND, Jean-Christophe, 91240 SAINT MICHEL SUR ORGE (FR); TRAVERS, Laurent, 92360 MEUDON LA FORET (FR); OLLIVIER, Yannick, 91940 LES ULIS (FR)
(74) Mandataire: IPAZ
(86) Numéro de dépôt international: PCT/EP2019/061115
(87) Numéro de publication internationale: WO 2019/211305

(56) Documents cités:
- EP-A1- 1 821 146
- JP-A- S63 297 294
- JP-A- 2004 119 291
- US-A- 4 878 989
- US-A- 5 431 735

## Description

### Domaine technique

La présente invention concerne un microscope électronique en transmission équipé d'au moins une source de jet de matière balistique, tel que par exemple une source de jet de molécules balistique, ou encore une source de jet de radicaux balistique.

Le domaine de l'invention est le domaine de la microscopie électronique en transmission.

### Etat de la technique

L'épitaxie par jet moléculaires consiste à envoyer un ou plusieurs jets moléculaires vers un substrat, en vue de réaliser une croissance cristalline sur ledit substrat, en particulier sous forme de couche d'épaisseur nanométrique.

La microscope électronique en transmission est une technique d'imagerie bien connue, exploitant l'interaction d'un faisceau d'électrons émis vers un échantillon très mince à imager. Les électrons traversant l'échantillon sont exploités pour réaliser une image dudit échantillon, avec une résolution pouvant atteindre quelques centièmes de nanomètre.

Par conséquent, un microscope électronique en transmission (MET) propose une précision d'imagerie particulièrement bien adaptée pour observer et contrôler une opération de croissance cristalline par jet de matière balistique. Cependant, il n'existe aucun MET permettant de réaliser une croissance par jet de matière balistiques et d'observer ladite croissance, avec une architecture aboutie et ergonomique.

Un but de la présente invention est de remédier aux inconvénients précités.

Un autre but de la présente invention est de proposer un microscope électronique en transmission permettant de réaliser une croissance par jet de matière balistique d'architecture aboutie, simple et offrant une grande flexibilité.

Un autre but de la présente invention est de proposer un microscope électronique en transmission permettant de réaliser une croissance par jet de matière balistique d'utilisation ergonomique.

### Exposé de l'invention

Au moins un de ces buts est atteint avec un microscope électronique en transmission (MET) selon la présente invention telle que définie par la revendication 1.

Par « jet de matière balistique », on entend un jet de matière qui projette des particules de matière (chaque particule ayant une masse inférieure à 500 unités de masse atomique et/ou inférieure à 10⁻²⁴ kg) à la manière d'un projectile, sans perturbation, sur les trajectoires de ces particules, par un gaz ou par d'autres particules mobiles au moins jusque dans la chambre objet et/ou dans la chambre objet). Ainsi, un « jet de matière balistique » est constitué de particules (chaque particule ayant une masse inférieure à 500 unités de masse atomique et/ou inférieure à 10⁻²⁴ kg) qui ne subissent pas de déviation de leur trajectoire engendrée par des collisions avec d'autres particules mobiles au moins jusque dans la chambre objet et/ou dans la chambre objet). Ainsi, un « jet de matière balistique » est constitué de particules ayant des trajectoires rectilignes au moins jusque dans la chambre objet et/ou dans la chambre objet).

Ainsi, l'invention propose un MET doté d'une source de jet de matière balistique externe, montée sur la colonne dudit MET de manière étanche et en regard d'un port prévu sur la colonne et permettant d'envoyer un jet balistique de matière dans la chambre objet.

L'architecture proposée par la présente est aboutie et peu complexe car elle évite de placer la source balistique dans l'espace réduit de la chambre objet.

De plus, le microscope selon l'invention est flexible et simple d'utilisation car, la source balistique étant externe à la chambre objet, il y a moins de contraintes/limitations sur la nature et les dimensions de ladite source.

Par ailleurs, le microscope selon l'invention est ergonomique d'utilisation et de maintenance, car il est possible d'intervenir sur la source balistique sans accès à la chambre objet, ni intervention sur aucun autre organe du microscope.

Suivant un mode de réalisation non limitatif, le microscope selon l'invention peut comprendre plusieurs sources de jets de matière balistiques fixées à la colonne.

Ainsi, il est possible de réaliser des jets balistiques de matière suivant au moins deux directions différentes, de manière simultanée ou non.

Au moins deux sources peuvent être fixées à la colonne du microscope, chacun en regard d'un port individuel. Alternativement, au moins deux sources peuvent être fixées à la colonne en regard d'un port commun.

Au moins une source peut être disposée pour émettre un jet de matière balistique suivant une direction montante par rapport à la direction horizontale. Ainsi, il est possible de mettre en œuvre une charge de matière liquide dans ladite source.

Au moins une source de jet est disposée à l'extérieur de la colonne et comprend un collimateur de jet de matière vers une direction déterminée, traversant le port et débouchant dans la chambre objet de sorte que le jet de matière (ou au moins une partie du jet de matière) quitte ladite source dans ladite chambre objet.

Plus précisément, au moins une source de jet est de préférence disposée à l'extérieur de la colonne et comprend un collimateur de jet de matière qui sélectionne les particules du jet de matière dont la trajectoire rectiligne est dirigée selon une direction déterminée, traversant le port et débouchant dans la chambre objet de sorte que seule la partie du jet de matière quittant ladite source dans la direction exacte de l'échantillon pénètre dans ladite chambre objet.

Avantageusement, au moins une source peut comprendre une combinaison quelconque d'un ou plusieurs générateurs de jets de matières choisis parmi :
- une cellule à effusion,
- une source à plasma,
- un générateur de radicaux par craquage thermique,
- un évaporateur à bombardement électronique.

En particulier, au moins une source peut comprendre au moins deux générateurs de jets utilisant des matériaux sources différents. Ainsi, il est possible de réaliser des jets différents matériaux, de manière simultanée ou non.

Alternativement, ou en plus, au moins une source peut comprendre au moins deux générateurs de jets utilisant des matériaux sources identiques. Ainsi, il est possible d'augmenter la quantité des jets de matières.

Suivant une caractéristique avantageuse, au moins une source peut comprendre au moins un générateur de jet de matière amovible au travers d'une ouverture d'accès prévue sur ladite source.

Ainsi, il est possible de remplacer le générateur de manière simple et rapide.

De plus, après avoir enlevé le générateur, il est possible d'utiliser l'ouverture d'accès pour vérifier et ajuster l'orientation de la source, ou pour observer l'alignement de la source avec un substrat positionné dans la chambre objet, ou avec le porte échantillon du microscope.

Suivant un exemple de réalisation particulier, le générateur peut être solidaire d'une bride de montage refermant l'ouverture d'accès. Ainsi, la manipulation du générateur en vue de sa mise en place et de son remplacement, est encore plus simplifiée.

Préférentiellement, au moins une source peut comprendre au moins un collimateur de jet de matière vers une direction déterminée.

Un tel collimateur permet d'obtenir un jet directionnel et très précis, et de retenir/piéger les particules de matières qui ne peuvent pas atteindre le substrat visé du fait de leurs directions.

Le collimateur est de préférence agencé pour piéger des particules du jet de matière qui ne sont pas émises dans la direction déterminée et éviter que ces particules non émises dans la direction déterminée ne passent dans la chambre objet.

Suivant un exemple de réalisation non limitatif, un tel collimateur peut présenter une ouverture de sortie de jet de matière dont la section est comprise entre 0.5mm² et 1.5mm², et en particulier de 1mm².

Avantageusement, le collimateur peut être réalisé en un matériau poreux, tel que par exemple en TiO₂. Un tel matériau présente une plus grande capacité de piégeage des matières non collimatés, et donc une meilleure protection du microscope.

Lorsqu'une source comprend plusieurs générateurs, ladite source peut comprendre un collimateur commun à au moins deux générateurs.

Alternativement ou en plus, au moins deux générateurs peuvent chacun être associé à un collimateur individuel.

Avantageusement, le microscope selon l'invention peut comprendre des moyens pour maintenir le collimateur à une température suffisamment basse pour que des particules du jet de matière émises en amont et en direction des parois du collimateur y soient piégées , cette température suffisamment basse étant de préférence inférieure à 25 °C.

Avantageusement, au moins un collimateur peut présenter une section qui diminue dans le sens du jet de matière. Ainsi, le collimateur peut recevoir et piéger une plus grande quantité de matières non collimatées en entrée, tout en évitant son obstruction rapide par la matière piégée.

Suivant un mode de réalisation, la section du collimateur peut diminuer de manière continue. Par exemple, le collimateur peut présenter une forme conique de section circulaire, triangulaire, etc.

Suivant un mode de réalisation, la section du collimateur peut diminuer de manière discontinue ou discrète. Par exemple, le collimateur peut présenter plusieurs conduits dont les sections sont de plus en plus petites.

Au moins une source du microscope selon l'invention peut avantageusement comprendre au moins un obturateur pour arrêter le jet de matière vers la chambre objet.

Un tel obturateur permet de démarrer, d'arrêter, ou de reprendre l'émission du jet de matière de manière rapide et réactive.

Un tel obturateur peut être disposé après la sortie du générateur de matière, ou avant l'entrée du collimateur dans le sens de propagation du jet.

Un tel obturateur peut être en forme d'un cache ou d'une paroi.

Un tel obturateur peut aussi être une vanne pointeau venant obturer la sortie du générateur ou l'entrée du collimateur.

Un tel obturateur peut être mis en position d'obturation ou déplacé par un mouvement rotation, éventuellement associé à un mouvement de translation préalable ou postérieur, en particulier manuellement.

Un tel obturateur peut être actionné grâce à un axe manipulable depuis l'extérieur de la source.

Selon l'invention, au moins une source peut comprendre au moins un écran thermique disposé autour d'un générateur de jet de matière.

En particulier, au moins une source peut comprendre plusieurs écrans thermiques, en particulier concentriques, disposés autour d'un générateur de jet de matière.

Au moins un écran thermique peut être réalisé en métal.

Lorsque la source comprend un collimateur de jet de matière, au moins une partie de ce dernier peut réaliser un écran thermique.

Avantageusement, au moins une source peut comprendre, au moins une ouverture de pompage pour y relier un dispositif de pompage ajustant, et en particulier faisant baisser, la pression à l'intérieur de ladite source.

Une telle ouverture de pompage peut être munie d'un connecteur ou d'un joint pour réaliser la liaison avec le dispositif de pompage.

La source peut être reliée au dispositif de pompage grâce à un tombac.

Le dispositif de pompage peut être prévu pour obtenir une pression résiduelle inférieure à 10⁻⁴Torr pendant le fonctionnement du générateur. Le dispositif de pompage permet en outre de conférer le caractère balistique du jet de matière.

Suivant une caractéristique particulièrement avantageuse, le microscope selon l'invention peut comprendre, pour au moins une source, un moyen d'ajustement, dit de visée, pour ajuster la direction du jet de matière, suivant au moins une direction de l'espace, en particulier suivant les trois directions de l'espace.

Le moyen d'ajustement de visée peut permettre un ajustement suivant plusieurs directions, et en particulier de manière individuelle pour chaque direction.

Pour au moins une source, le moyen d'ajustement de visée peut comprendre :
- un soufflet disposé entre ladite source et la colonne du microscope ; et
- au moins un moyen de modification de la compression dudit soufflet suivant au moins un point.

Le moyen de modification peut comprendre une vis permettant de compresser ou de détendre le soufflet en un point de sa périphérie.

Avantageusement, le moyen d'ajustement peut comprendre trois vis réparties de manière équiangle, ou équidistante.

Pour au moins une source, le moyen d'ajustement de visée peut comprendre au moins un moyen de modification de la position d'un collimateur de jet de matière au sein de ladite source.

Suivant un exemple de réalisation, le moyen d'ajustement de visée peut comprendre un moyen de modification de la position du collimateur uniquement. Un tel moyen d'ajustement peut comprendre :
- un soufflet auquel est fixé ledit collimateur, et autorisant le déplacement dudit collimateur ; et
- une ou plusieurs vis d'ajustement modifiant la position du collimateur.

Le microscope selon l'invention comprend au moins une source de jet disposée à l'extérieur de la colonne et comprenant une partie, en particulier un collimateur, traversant le port et débouchant dans la chambre objet de sorte que le jet de matière quitte ladite source dans ladite chambre-objet.

Dans ce cas, la partie distale de la source traverse la paroi de la colonne du microscope et pénètre dans la chambre objet.

En plus, au moins une source de jet peut être disposée à l'extérieur de la colonne, de sorte que le jet de matière quitte ladite source avant le port, ou avant la chambre objet.

Dans ce cas, la source ne pénètre pas dans le port, respectivement dans la chambre objet.

Avantageusement, pour au moins une source, l'intérieur de ladite source communique avec la chambre objet uniquement au travers d'un collimateur de jet de matière.

Ce collimateur de jets présentant une ouverture de sortie de section très petite, la conductance entre la chambre objet et la source est *ipso facto* très faible. Il est alors possible de maintenir un différentiel d'au moins trois décades entre la source et la chambre objet. Avantageusement, la faible conductance permet de faire fonctionner une source quelconque sans affecter de façon importante la pression résiduelle dans la chambre objet.

Il est par exemple possible de maintenir une pression de l'ordre de 10⁻⁷ Torr dans la chambre objet tout en ayant une pression de l'ordre de 10⁻⁴ Torr dans la source.

Selon un exemple de réalisation nullement limitatif du microscope selon l'invention, au moins une source peut comprendre :
- un générateur de jet de matière balistique, tel qu'une cellule d'effusion dans laquelle le matériau source est chauffé par un filament résistif ou par un bombardement électronique,
- deux écrans thermiques concentriques autour dudit générateur,
- un collimateur de jet de matière en aval dudit générateur,
- un obturateur entre ledit générateur et ledit collimateur,
- un moyen d'ajustement de la direction de visée.

### Description des figures et modes de réalisation

D'autres avantages et caractéristiques apparaîtront à l'examen de la description détaillée d'exemples nullement limitatifs, et des dessins annexés sur lesquels :
- la FIGURE 1 est une représentation schématique partielle, selon une vue en coupe de dessus, d'un premier exemple de réalisation d'un microscope selon l'invention ;
- la FIGURE 2 est une représentation schématique partielle, selon une vue en coupe de dessus, d'un autre exemple de réalisation d'un microscope selon l'invention ;
- la FIGURE 3 est une représentation schématique partielle, selon une vue de coupe, d'un premier exemple de réalisation d'une source de jet de matière balistique pouvant être mise en œuvre dans un microscope selon l'invention ;
- la FIGURE 4 est une représentation schématique partielle, selon une vue éclatée, d'un deuxième exemple de réalisation d'une source de jet de matière balistique pouvant être mise en œuvre dans un microscope selon l'invention ; et
- la FIGURE 5 est une représentation schématique partielle, selon une vue de coupe, d'un autre exemple de réalisation d'une source de jet de matière balistique pouvant être mise en œuvre dans un microscope selon l'invention.

Il est bien entendu que les modes de réalisation qui seront décrits dans la suite ne sont nullement limitatifs.

Sur les figures, les éléments communs à plusieurs figures conservent la même référence.

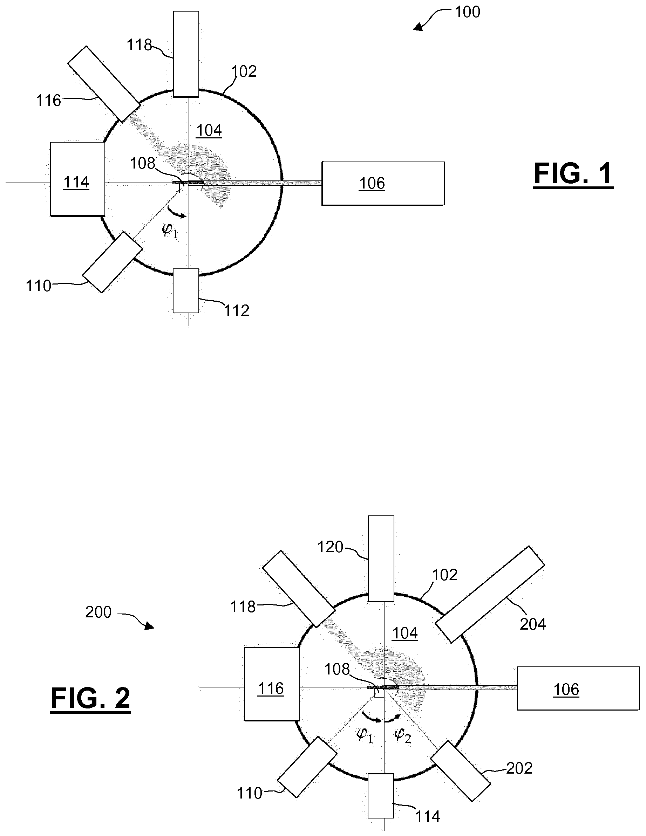

La FIGURE 1 est une représentation schématique, en coupe, selon une vue de dessus, d'un premier exemple de réalisation non limitatif d'un microscope électronique en transmission (MET) selon l'invention.

Le microscope 100, représenté sur la FIGURE 1, comprend une colonne 102 délimitant une chambre à vide 104, également appelé chambre objet, comprenant des pièces polaires (non représentes sur la FIGURE 1) du MET.

Le microscope 100 comprend également un porte échantillon 106 plongeant dans la chambre à vide 104. Dans la chambre à vide 104, le porte échantillon 106 forme un support pour un échantillon, et en particulier un substrat 108.

Le microscope 100 selon l'invention comporte une source de jet de matière balistique 110, dirigée vers le substrat 108. La source 110 émet un jet balistique de matière sur le substrat 108 pour réaliser une croissance de cristaux sur ledit substrat 108.

La source de jet de matière balistique 110 est montée sur la paroi de la colonne 102 du microscope 100, et se trouve, au moins en partie à l'extérieur de la chambre à vide 104.

En outre, le MET selon l'invention 100 peut comprendre, de manière connue, un détecteur de rayons X 112, une pompe à vide 114, un dispositif 116 de condensation de vapeurs (appelé « cold trap » en anglais), ainsi que d'autres composants standards dans un MET tels que des diaphragmes 118.

La source 110 de jets balistiques de matière est orientée suivant une direction formant un angle ϕ₁ par rapport à la direction du détecteur 114. Préférentiellement, cet angle ϕ₁ est inférieur ou égal à 45°.

La FIGURE 2 est une représentation schématique, en coupe, selon une vue de dessus, d'un deuxième exemple de réalisation non limitatif d'un microscope électronique en transmission (MET) selon l'invention.

Le microscope 200, représenté sur la FIGURE 2, comprend tous les organes du microscope 100 de la FIGURE 1.

Le microscope 200 comprend en outre une deuxième source 202 de jet de matière balistique, dirigée vers le substrat 108. La source 202 émet un jet balistique de matière sur le substrat 108 pour réaliser une croissance de cristaux sur ledit substrat 108, simultanément à la source 110, ou à tour de rôle.

La source de jet de matière balistique 202 est montée à la paroi de la colonne 102 du microscope 100, et se trouve, au moins en partie à l'extérieur de la chambre à vide 104.

La source 202 de jet balistique de matière est orientée suivant une direction formant un angle ϕ₂ par rapport à la direction du détecteur 114. Préférentiellement, cet angle ϕ₂ est inférieur ou égal à 45°.

Préférentiellement, les sources 110 et 202 sont disposées de part et d'autre de la direction du détecteur 114, comme montré sur la FIGURE 2.

Le microscope 200 peut également comprendre une source à plasma 204 dirigée vers le substrat 108. La source à plasma 112 est montée à la paroi de la colonne 102 du microscope 100, et se trouve, au moins en partie à l'extérieur de la chambre à vide 104.

De manière générale, le microscope selon l'invention peut comprendre un ou plusieurs sources de jets balistiques de matière et n'est pas limité à une ou deux sources.

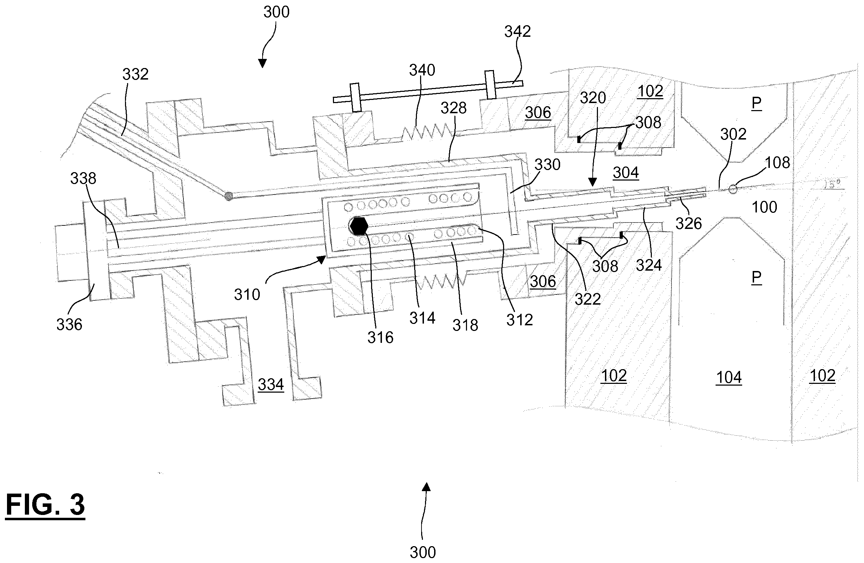

La FIGURE 3 est une représentation schématique partielle, selon une vue en coupe, d'un premier exemple de réalisation non limitatif d'une source de jet de matière balistique pouvant être mise en œuvre dans un microscope selon l'invention.

La source 300 peut être l'une quelconque des sources 110, 202 et 204 des FIGURES 1 et 2.

La source 300 de la FIGURE 3, est représentée montée sur la colonne du microscope, qui peut être le microscope 100 ou 200 des FIGURES 1 et 2, dont on voit les pièces polaires référencées P.

La source 300 de jets de matière balistiques est orientée, suivant une direction 302. La source 300 est solidaire de la colonne 102 du microscope, en regard d'une ouverture 304 appelée port, prévue sur la colonne 102 du microscope.

Comme montré sur la FIGURE 3, la source 300 se trouve à l'extérieur de la colonne 102 du microscope et est solidaire de la paroi de la colonne 102 par l'extérieur.

En particulier, une pièce intermédiaire 306, optionnelle, est insérée dans le port 304, de manière étanche, par exemple en utilisant des joints 308 en élastomères ou en cuivre, en particulier aux décrochements de ladite pièce intermédiaire 306. L'assemblage de la pièce intermédiaire 306 dans le port 304 peut être réalisé par tout moyen connu, par exemple par vissage. La pièce intermédiaire 306 est rigidement et solidairement fixée à la colonne 102.

La source 300 comprend un générateur de jet de matière, et en particulier une cellule d'effusion 310.

La cellule 310 comprend un creuset 312 comportant un double filament électrique résistif 314 sous tension pour chauffer une charge de matière 316 placée dans ledit creuset 312. Les molécules générées dans le creuset sortent de ladite cellule d'effusion 310 par une ouverture prévue du côté du microscope.

La cellule d'effusion 310 comprend un premier écran thermique 318, par exemple réalisé en métal réfractaire, pour isoler thermiquement ladite cellule d'effusion 310, et en particulier le creuset 312.

La source 300 comprend en outre, en aval de la cellule d'effusion 310 un collimateur 320 de jet de matière.

Le collimateur 320 comporte trois zones de sections différentes : une zone d'entrée 322 se trouvant du côté de la cellule d'effusion 310, une zone intermédiaire 324 et une zone de sortie 326 se trouvant du côté de l'échantillon 108. Le jet de matière entre dans le collimateur 320 par la zone d'entrée 322 et sort du collimateur 320 par la zone de sortie 326. Les sections des zones 322-326 diminuent de sorte que la section de la zone d'entrée 322 est plus grande que celle de la zone intermédiaire 324, elle-même plus grande que celle de la zone de sortie 326.

L'architecture, en plusieurs zones 322-326 de sections différentes, du collimateur 320 permet de piéger un grand nombre de molécules ou particules qui ne sont pas émises dans la direction de visée 302 et éviter que ces molécules ou particules inutiles à l'expérimentation ne passent dans la chambre objet 104 et contaminent le microscope.

La section de la zone de sortie 326 est de l'ordre de 1 mm². C'est aussi la section du jet de matière quittant le collimateur 320, et donc la source 300.

Du côté de la zone d'entrée 322, le collimateur 320 est prolongé autour de la cellule d'effusion 310 par un deuxième écran thermique 328, par exemple métallique. Le deuxième écran thermique 328 entoure et englobe le premier écran thermique 318, lui-même englobant le creuset 312. La combinaison des premier et deuxième écrans thermiques 318 et 328 permet de protéger les joints d'étanchéité et d'obtenir une isolation thermique telle que la température de la colonne 102 du microscope soit inférieure ou égale à 60°C alors que la température dans la cellule d'effusion 310 peut être de l'ordre de 1000°C.

La source 300 comprend en outre un obturateur de jet, se présentant sous la forme d'un cache 330 positionné entre la sortie de la cellule d'effusion 310 et l'entrée du collimateur 320.

L'obturateur 330 permet de couper le jet de molécules vers le substrat 108 de manière rapide et réactive. La position de l'obturateur 330 peut être modifiée par rotation, grâce à un axe de commande 332.

La source 300 comprend en outre une ouverture de pompage 334 permettant d'y connecter une pompe turbo-moléculaire, par exemple grâce à une bride de pompage combinée à un tombac (non représenté). Ainsi, il est possible de créer, par pompage, un vide dans la source 300, par exemple de l'ordre de 10⁻⁸ Torr sans mise en fonctionnement de la source.

Il est à remarquer que l'intérieur de la source 300 n'est en communication avec la chambre-objet qu'au travers du collimateur 320, et en particulier via la zone de sortie 326 du collimateur 320, cette zone de sortie 326 présentant une section très petite, par exemple de l'ordre de 1 mm². Ainsi, il est possible de créer un différentiel de pression entre la source et la chambre objet 104 de l'ordre d'au moins trois décades : par exemple il est possible de maintenir une pression de 10⁻⁷ Torr dans la chambre objet 104 avec une pression de 10⁻⁴ Torr dans la source 300 en fonctionnement.

En outre, la cellule 310 est solidairement reliée, par exemple grâce à au moins une tige, à une bride de montage 336 refermant une ouverture d'accès 338. Ainsi, il est possible d'enlever la cellule d'effusion 310 par l'ouverture d'accès 338, pour la remplacer ou la réparer.

Par ailleurs, après avoir enlevé la cellule d'effusion 310, il est possible d'utiliser l'ouverture d'accès 338 pour vérifier et ajuster l'orientation de la source 300 et en particulier de l'axe de son collimateur 302, par rapport au porte échantillon. On réalise ainsi l'alignement de la source de jet moléculaire 300 avec le substrat 108 fixé sur le porte échantillon du microscope 100.

De plus, le microscope comprend en outre un soufflet 340, disposé entre d'une part la source 300 et d'autre part la colonne 102 du microscope, et plus précisément la pièce intermédiaire 306.

Le soufflet 340 est fixé rigidement et de manière étanche d'un côté à la source 300 et de l'autre côté à la pièce intermédiaire 306. Le soufflet 340 peut être fixé à la source 300, respectivement à la pièce intermédiaire 306, par vissage et en utilisant un joint d'étanchéité en cuivre monté sur une bride en inox.

Le microscope peut comprendre trois tiges filetées 342, positionnées en trois positions équiangle autour de soufflet 340. Chaque tige 340 est en prise de part et d'autre du soufflet 340 et peut être vissée ou dévissée pour modifier la compression dudit soufflet 340, et par voie de conséquence, l'orientation de la source 300 solidaire dudit soufflet 140. Il est donc possible de modifier et d'ajuster la direction 302 du jet de molécules grâce aux tiges filetés 342.

Dans l'exemple représenté sur la FIGURE 1, la source 300 est orientée suivant une direction 302 montante vers l'échantillon 108, par rapport à la direction horizontale. Ainsi, il est possible d'utiliser une charge de matériau 316 liquide, tout en évitant que ladite charge de matériau 316 ne s'écoule hors du creuset de la cellule 310.

Le soufflet 340 et les tiges 342 peuvent faire partie de la source 300, ou être prévus sur le microscope.

Dans l'exemple décrit sur la FIGURE 3, la source 300 de jet de matière balistique comprend un unique générateur de jet de matière balistique, à savoir la cellule d'effusion 310.

Bien entendu, la source de jet de matière balistique n'est pas limitée à un unique générateur et peut comprendre plusieurs générateurs de jets de matière balistiques.

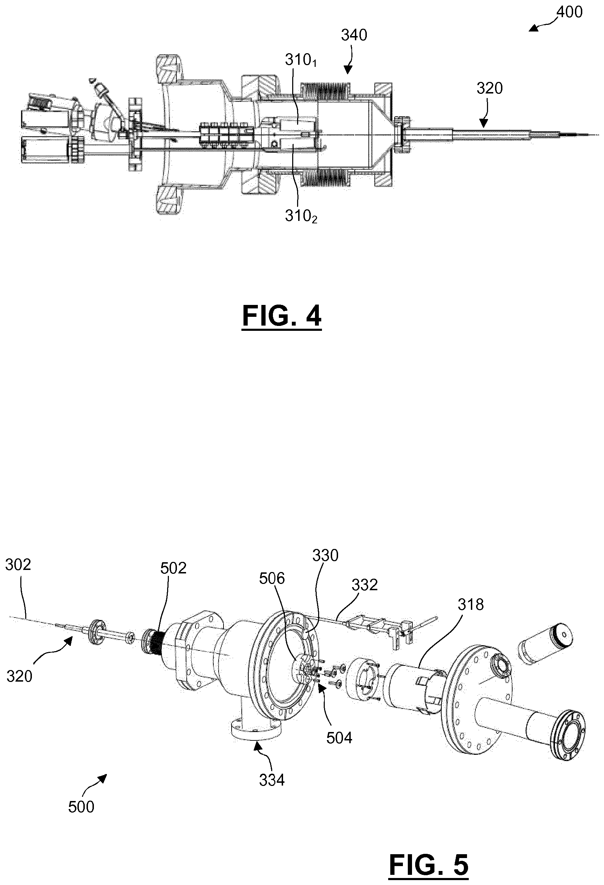

La FIGURE 4 est une représentation schématique, selon une vue en coupe, d'un autre exemple d'une source de jets de matière balistiques pouvant être mise en œuvre dans un microscope selon l'invention.

La source 400, représentée sur la FIGURE 4, peut être l'une quelconque des sources 110, 202 ou 204 des FIGURES 1 et 2.

La source 400 comprend, à la différence de la source 300 de la FIGURE 3, deux générateurs de jets de matière balistiques, à savoir les générateurs 310₁ et 310₂.

Les générateurs 310₁-310₂ peuvent être identiques ou différents.

Les générateurs 310₁-310₂ peuvent générer des jets balistiques d'un même matériau ou de matériaux différents.

Par exemple, chaque générateur 310₁-310₂ peut être un générateur de jets de molécules ou un générateur de jets de radicaux ou encore un générateur à plasma.

En particulier, chaque générateur 310₁ et 310₂ peut être identique à la cellule d'effusion 310.

La source 400 peut comprendre les mêmes organes que la source 300 de la FIGURE 3, ou des organes réalisant les mêmes fonctions que celles des organes de la source 300.

Au moins un de ces organes peut être individuel à au moins un, en particulier chaque, générateur 310₁ et 310₂. Par exemple, la source 400 peut comprendre un écran thermique individuel pour au moins un, en particulier chaque, générateur 310₁ et 310₂.

Alternativement ou en plus, au moins un de ces organes peut être commun aux deux générateurs 310₁ et 310₂. Par exemple, la source 400 peut comprendre le collimateur de jets 320 ou le soufflet 340 commun aux deux générateurs 310₁ et 310₂.

Dans les exemples décrits en référence aux FIGURES 3 et 4, la direction des jets de matière balistiques est ajustée en ajustant l'orientation de la totalité de la source, grâce à un soufflet, disposé entre ladite source et le microscope.

Bien entendu, il est possible d'ajuster la direction des jets de matière balistiques en ajustant l'orientation d'une partie uniquement de la source, le reste de la source restant fixe. Par exemple, il est possible d'ajuster la direction du jet de matière balistique en ajustant uniquement l'orientation du collimateur de la source.

La FIGURE 5 est une représentation schématique, selon une vue éclatée, d'un autre exemple d'une source de jet de matière balistique pouvant être mise en œuvre dans un microscope selon l'invention.

La source 500, représentée sur la FIGURE 5, peut être l'une quelconque des sources 110, 202 ou 204 des FIGURES 1 et 2.

Dans la source 500, la direction du jet de matière est ajustée en ajustant uniquement l'orientation du collimateur 320.

Pour ce faire, la source 500 comprend un soufflet 502, étanche, disposé dans ladite source 500.

Le collimateur 320 est monté solidaire de la source 500, de manière étanche, par l'intermédiaire d'un soufflet orientable 502. En particulier, le soufflet 502 est disposé autour du collimateur 320, à l'instar d'un anneau, de sorte que le collimateur traverse le soufflet 502. D'autre part le soufflet 502 est solidaire d'une pièce, ou d'une surface, fixe de la source 500. Ainsi, le collimateur 320 est mobile dans le soufflet 502 de sorte que son orientation peut être modifiée.

La source 500 comprend en outre des vis 504 venant en prise d'une part sur le collimateur 320, mobile dans le soufflet 502, et d'autre part sur une pièce de support 506 solidaire d'une pièce, ou d'une surface, fixe de la source 500.

Ainsi, en vissant ou en dévissant la ou les vis de fixation, il est possible de modifier l'orientation du collimateur 320, et donc le jet de matière balistique dans la chambre objet.

Bien entendu, la source 500 peut comprendre un ou plusieurs générateurs de jets balistiques, à l'instar de la source 400 de la FIGURE 4.

Selon la variante considérée de ce qui vient d'être décrit :
- différentes variantes et/ou combinaison de générateur(s) peuvent être utilisées selon l'invention ; en particulier, un générateur tel que :
   ∘ source à plasma,
   ∘ générateur de radicaux par craquage thermique,
   ∘ évaporateur à bombardement électronique,
   permet de générer un jet de matière balistique, par exemple en extrayant des particules d'intérêt et en isolant ces particules d'intérêt d'autres particules pouvant perturber la trajectoire de ces particules d'intérêt (par exemple par la mise en œuvre d'une pression différentielle entre le générateur à pression élevée et le collimateur à basse pression), et/ou
- le microscope selon l'invention peut comprendre des moyens pour maintenir le collimateur à une température suffisamment basse pour que des particules du jet de matière émises en amont et en direction des parois du collimateur y soient piégées, cette basse température étant de préférence inférieure à 25 °C.
- la pression à l'intérieur de chaque source de jet de matière balistique (de préférence au niveau de son collimateur) et/ou à l'intérieur de la chambre objet et/ou entre chaque source de jet de matière balistique et la chambre objet est de préférence inférieure à 10⁻² Pa, de manière encore plus préférentielle inférieure à 10⁻⁵ Pa.

Bien sûr, l'invention n'est pas limitée aux exemples qui viennent d'être décrits et de nombreux aménagements peuvent être apportés à ces exemples sans sortir du cadre de l'invention telle que définie par la revendication 1.

## Revendications

1. Microscope électronique en transmission (100;200) comprenant :
- une colonne (102) délimitant une chambre objet (104),
- au moins une source (110,202,204,300,400,500) de jet de matière balistique :
- à l'extérieur de ladite chambre objet (104), et
- fixée de manière étanche à ladite colonne (102), en regard d'une ouverture (304), dite port, prévue sur ladite colonne (102) ; ladite au moins une source de jet (110,202,204,300,400,500) étant disposée à l'extérieur de ladite colonne (102) et comprenant un collimateur (320) de jet de matière vers une direction déterminée ;
**caractérisé en ce que** ledit collimateur de jet de matière traverse le port (304) et débouche dans la chambre objet (104) de sorte qu'une partie du jet de matière quitte ladite source (110,202,204,300,400,500) dans ladite chambre objet (104).

2. Microscope (100;200) selon la revendication précédente, **caractérisé en ce que** le collimateur est agencé pour piéger des particules du jet de matière qui ne sont pas émises dans la direction déterminée et éviter que ces particules non émises dans la direction déterminée ne passent dans la chambre objet.

3. Microscope (100;200) selon l'une quelconque des revendications précédentes, **caractérisé en ce qu'**au moins une source (110,202,204,300,400,500) comprend une combinaison quelconque d'un ou plusieurs générateurs (310,310₁,310₂) de jets de matières choisis parmi :
- une cellule à effusion,
- une source à plasma,
- un générateur de radicaux par craquage thermique,
- un évaporateur à bombardement électronique.

4. Microscope (100;200) selon la revendication précédente, **caractérisé en ce qu'**au moins une source (300) comprend au moins un générateur de jet de matière (310) amovible au travers d'une ouverture (338) prévue sur ladite source (300).

5. Microscope (100;200) selon l'une quelconque des revendications précédentes, **caractérisé en ce que** le collimateur (320) présente une section qui diminue dans le sens du jet de matière.

6. Microscope (100;200) selon l'une quelconque des revendications précédentes, **caractérisé en ce qu'**au moins une source (300;400;500) comprend au moins un obturateur (330) pour arrêter le jet de matière vers la chambre objet (104).

7. Microscope (100;200) selon l'une quelconque des revendications précédentes, **caractérisé en ce qu'**au moins une source (300;400;500) comprend au moins un écran thermique (318,328) disposé autour d'un générateur de jet de matière (310).

8. Microscope (100;200) selon l'une quelconque des revendications précédentes, **caractérisé en ce qu'**au moins une source (300;400;500) comprend une ouverture de pompage (334) pour y relier un dispositif de pompage ajustant, et en particulier faisant baisser, la pression à l'intérieur de ladite source (300;400;500).

9. Microscope (100;200) selon l'une quelconque des revendications précédentes, **caractérisé en ce qu'**il comprend, pour au moins une source (300;400;500), un moyen d'ajustement, dit de visée, pour ajuster la direction du jet de matière, suivant au moins une direction de l'espace.

10. Microscope (100;200) selon la revendication précédente, **caractérisé en ce que**, pour au moins une source (300;400), le moyen d'ajustement de visée comprend :
- un soufflet (340) disposé entre ladite source (300;400) et la colonne (102) dudit microscope ; et
- au moins un moyen (342) de modification de la compression dudit soufflet (340) suivant au moins un point, en particulier sous la forme d'une vis.

11. Microscope (100;200) selon la revendication 10, **caractérisé en ce que**, pour au moins une source (500), le moyen d'ajustement de visée comprend au moins un moyen (502,504) de modification de la position du collimateur (320) de jet de matière au sein de ladite source (100;200).

12. Microscope (100;200) selon l'une quelconque des revendications précédentes, **caractérisé en ce que** pour au moins une source (110,202,204,300,400,500), l'intérieur de ladite source communique avec la chambre objet (104) uniquement au travers du collimateur (320) de jet de matière.

13. Microscope (100;200) selon la revendication 1, **caractérisé en ce qu'**au moins une source (300) comprend :
- un générateur (310) de jet de matière balistique, tel qu'une cellule d'effusion,
- deux écrans thermiques concentriques (318,328) autour dudit générateur (310),
- un collimateur (320) de jet de matière en aval dudit générateur (310),
- un obturateur (330) entre ledit générateur (310) et ledit collimateur (320), et
- un moyen (340,342) d'ajustement de la direction de visée.

14. Microscope (100;200) selon l'une quelconque des revendications précédentes, **caractérisé en ce qu'**il comprend des moyens pour maintenir le collimateur à une température suffisamment basse pour que des particules du jet de matière émises en amont et en direction des parois du collimateur y soient piégées , cette température suffisamment basse étant de préférence inférieure à 25 °C.

## Patentansprüche

1. Transmissionselektronenmikroskop (100;200), umfassend:
- eine Säule (102), die eine Objektkammer (104) begrenzt,
- mindestens eine Quelle (110,202,204,300,400,500) eines Strahls aus ballistischem Material:
- außerhalb der Objektkammer (104), und
- an dieser Säule (102) abgedichtet befestigt in Bezug auf eine an dieser Säule (102) vorgesehene, auch als Port zu bezeichnende Öffnung (304);
wobei die mindestens eine Strahlquelle (110,202,204,300,400,500) außerhalb dieser Säule (102) angeordnet ist und einen Kollimator (320) für den Materialstrahl in eine bestimmte Richtung umfasst;
**dadurch gekennzeichnet, dass** der Kollimator für den Materialstrahl den Port (304) durchquert und in die Objektkammer (104) mündet, derart, dass ein Teil des Materialstrahls die Quelle (110,202,204,300,400,500) in der Objektkammer (104) verlässt.

2. Mikroskop (100;200) nach dem vorhergehenden Anspruch, **dadurch gekennzeichnet, dass** der Kollimator dazu eingerichtet ist, Partikel des Materialstrahls, die nicht in der bestimmten Richtung emittiert werden, abzufangen und zu verhindern, dass diese Partikel, die nicht in der bestimmten Richtung emittiert werden, in die Objektkammer gelangen.

3. Mikroskop (100;200) nach einem der vorhergehenden Ansprüche, **dadurch gekennzeichnet, dass** mindestens eine Quelle (110,202,204,300,400,500) eine beliebige Kombination aus einem oder mehreren Materialstrahlgeneratoren (310,310₁,310₂) umfasst, die ausgewählt sind aus:
- einer Effusionszelle,
- eine Plasmaquelle,
- einem Radikalgenerator nach dem Prinzip des thermischen Crackens,
- einem Elektronenbeschuss-Verdampfer.

4. Mikroskop (100;200) nach dem vorhergehenden Anspruch, **dadurch gekennzeichnet, dass** mindestens eine Quelle (300) mindestens einen Materialstrahlgenerator (310) umfasst, der durch eine an dieser Quelle (300) vorgesehene Öffnung (338) hindurch entfernbar ist.

5. Mikroskop (100;200) nach einem der vorhergehenden Ansprüche, **dadurch gekennzeichnet, dass** der Kollimator (320) einen Querschnitt aufweist, der sich in der Richtung des Materialstrahls verkleinert.

6. Mikroskop (100;200) nach einem der vorhergehenden Ansprüche, **dadurch gekennzeichnet, dass** mindestens eine Quelle (300;400;500) mindestens einen Verschluss (330) zum Stoppen des Materialstrahls in Richtung der Objektkammer (104) umfasst.

7. Mikroskop (100;200) nach einem der vorhergehenden Ansprüche, **dadurch gekennzeichnet, dass** mindestens eine Quelle (300;400;500) mindestens eine thermische Abschirmung (318,328) umfasst, die um einen Materialstrahlgenerator (310) angeordnet ist.

8. Mikroskop (100;200) nach einem der vorhergehenden Ansprüche, **dadurch gekennzeichnet, dass** mindestens eine Quelle (300;400;500) eine Pumpöffnung (334) zum Anschließen einer den Druck im Inneren der Quelle (300;400;500) einstellenden, und insbesondere senkenden, Pumpvorrichtung umfasst.

9. Mikroskop (100;200) nach einem der vorhergehenden Ansprüche, **dadurch gekennzeichnet, dass** es für mindestens eine Quelle (300;400;500) ein, auch als Visiermittel zu bezeichnendes, Einstellmittel zum Einstellen der Richtung des Materialstrahls in mindestens einer Richtung des Raums umfasst.

10. Mikroskop (100;200) nach dem vorhergehenden Anspruch, **dadurch gekennzeichnet, dass** für mindestens eine Quelle (300;400) das Visiereinstellmittel umfasst:
- einen Balg (340), der zwischen der Quelle (300;400) und der Säule (102) des Mikroskops angeordnet ist; und
- mindestens ein Mittel (342) zum Verändern der Kompression des Balgs (340) in Bezug auf mindestens einen Punkt, insbesondere in Form einer Schraubspindel.

11. Mikroskop (100;200) nach Anspruch 10, **dadurch gekennzeichnet, dass** für mindestens eine Quelle (500) das Visiereinstellmittel mindestens ein Mittel (502,504) zur Änderung der Position des Kollimators (320) für den Materialstrahl in der Quelle (100;200) umfasst.

12. Mikroskop (100;200) nach einem der vorhergehenden Ansprüche, **dadurch gekennzeichnet, dass** für mindestens eine Quelle (110,202,204,300,400,500) das Innere dieser Quelle mit der Objektkammer (104) nur über den Kollimator (320) für den Materialstrahl in Verbindung steht.

13. Mikroskop (100;200) nach Anspruch 1, **dadurch gekennzeichnet, dass** mindestens eine Quelle (300) umfasst:
- einen Generator (310) für einen ballistischen Materialstrahl, wie beispielsweise eine Effusionszelle,
- zwei thermische Abschirmungen (318,328) konzentrisch um den Generator (310),
- einen Kollimator (320) für den Materialstrahl stromabwärts dieses Generators (310),
- einen Verschluss (330) zwischen diesem Generator (310) und diesem Kollimator (320), und
- ein Mittel (340,342) zum Einstellen der Visierrichtung.

14. Mikroskop (100;200) nach einem der vorhergehenden Ansprüche, **dadurch gekennzeichnet, dass** es Mittel umfasst, um den Kollimator auf einer ausreichend niedrigen Temperatur zu halten, um Partikel des Materialstrahls, die stromaufwärts und in Richtung der Wände des Kollimators emittiert werden, dort abzufangen, wobei diese ausreichend niedrige Temperatur vorzugsweise kleiner als 25 °C ist.

## Claims

1. A transmission electron microscope (100;200) comprising:
- a column (102) delimiting an object chamber (104),
- at least one ballistic material jet source (110,202,204,300,400,500):
- outside said object chamber (104), and
- fixed in a sealed manner to said column (102), facing an opening (304), called port, provided on said column (102);
said at least one jet source (110,202,204,300,400,500) is arranged outside the column (102) and comprises a collimator (320) of the material jet towards a predetermined direction;
**characterized in that** said collimator passes through the port (304) and leads into the object chamber (104) so that a portion of the material jet exits said source (110,202,204,300,400,500) in said object chamber (104).

2. The microscope (100;200) according to the preceding claim, **characterized in that** the collimator is arranged to trap particles of the material jet which are not emitted in the predetermined direction and to prevent these particles that were not emitted in the predetermined direction from passing into the object chamber.

3. The microscope (100;200) according to any one of the preceding claims, **characterized in that** at least one source (110,202,204,300,400,500) comprises any combination of one or more material jet generators (310,310₁,310₂) selected from:
- an effusion cell,
- a plasma source,
- a radical generator using thermal cracking,
- an electron bombardment evaporator.

4. The microscope (100;200) according to the preceding claim, **characterized in that** at least one source (300) comprises at least one material jet generator (310) that can be removed through an opening (338) provided on said source (300).

5. The microscope (100;200) according to any one of the preceding claims, **characterized in that** the collimator (320) has a cross section which decreases in the direction of the material jet.

6. The microscope (100;200) according to any one of the preceding claims, **characterized in that** at least one source (300;400;500) comprises at least one shutter (330) for interrupting the material jet towards the object chamber (104).

7. The microscope (100;200) according to any one of the preceding claims, **characterized in that** at least one source (300;400;500) comprises at least one heat shield (318,328) arranged around a material jet generator (310).

8. The microscope (100;200) according to any one of the preceding claims, **characterized in that** at least one source (300;400;500) comprises a pump opening (334) for connection thereto of a pump device adjusting, and in particular lowering, the pressure inside said source (300;400;500).

9. The microscope (100;200) according to any one of the preceding claims, **characterized in that** it comprises, for at least one source (300;400;500), an adjustment means, called aiming adjustment means, for adjusting the direction of the material jet, in at least one spatial direction.

10. **The** microscope (100;200) according to the preceding claim, **characterized in that**, for at least one source (300;400), the aiming adjustment means comprises:
- a bellows (340) arranged between said source (300;400) and the column (102) of said microscope; and
- at least one means (342) for modifying the compression of said bellows (340) following at least one point, in particular in the form of a screw.

11. **The** microscope (100;200) according to claim 10, **characterized in that**, for at least one source (500), the aiming adjustment means comprises at least one means (502,504) for modifying the position of the material jet collimator (320) within said source (100;200).

12. The microscope (100;200) according to any one of the preceding claims, **characterized in that**, for at least one source (110,202,204,300,400,500), the inside of said source communicates with the object chamber (104) only though the material jet collimator (320).

13. The microscope (100;200) according to claim 1, **characterized in that** at least one source (300) comprises:
- a ballistic material jet generator (310), such as an effusion cell,
- two concentric heat shields (318,328) around said generator (310),
- a material jet collimator (320) downstream of said generator (310),
- a shutter (330) between said generator (310) and said collimator (320), and
- a means (340,342) for adjusting the aiming direction.

14. The microscope (100;200) according to any one of the preceding claims, **characterized in that** it comprises means for maintaining the collimator at a temperature that is low enough that the particles from the material jet emitted upstream and in the direction of the walls of the collimator are trapped there, this low enough temperature preferably being lower than 25°C.
